# EUROPÄISCHE PATENTSCHRIFT

(11) **EP 2 992 392 B1**
(45) Veröffentlichungstag und Bekanntmachung des Hinweises auf die Patenterteilung: **18.07.2018**
(21) Anmeldenummer: 14723366.2
(22) Anmeldetag: 28.04.2014
(51) Int. Cl.: G05B 19/042

(54) **ELEKTRISCHES INTERFACEMODUL**
ELECTRICAL INTERFACE MODULE
MODULE D'INTERFACE ÉLECTRIQUE

(30) Priorität: 29.04.2013 DE 102013207755
(43) Veröffentlichungstag der Anmeldung: 09.03.2016
(73) Patentinhaber: Phoenix Contact GmbH & Co. KG, 32825 Blomberg (DE)
(72) Erfinder: SCHOLZ, Peter, 33034 Brakel (DE); FELUX, Fritz, 32699 Extertal (DE); WIMMER, Lars-Peter, 31787 Hameln (DE)
(74) Vertreter: Schmelcher, Thilo
(86) Internationale Anmeldenummer: PCT/EP2014/058533
(87) Internationale Veröffentlichungsnummer: WO 2014/177482

(56) Entgegenhaltungen:
- EP-A1- 2 464 204
- EP-A2- 2 421 344
- DE-A1-102011 082 002
- DE-A1-102012 016 266

## Beschreibung

Die Erfindung betrifft ein elektrisches Interfacemodul.

Aus dem Stand der Technik sind elektrische Interfacemodule bekannt. Diese werden häufig in größeren elektrischen Anlagen verbaut.

Elektrische Interfacemodule werden im Zusammenhang mit dieser Erfindung im Allgemeinen als elektronische Komponenten der Automatisierungstechnik verstanden, die beispielsweise in Schaltschränken von industriellen Anlagen verwendet werden. Beispielhafte elektrische Interfacemodule sind elektronische Schaltgeräte, Motorsteuerungen, (Ethernet-) Netzwerkelemente, Feldbus-Komponenten und - Systeme, I/O-Geräte, Relais- und Schutzgeräte, Geräte der industriellen Kommunikationstechnik, Geräte der Mess-, Steuer- und Regelungstechnik, sowie Geräte zum Monitoring und Geräte zur Signalisierung.

Dabei ergibt sich das Problem, dass diese Komponenten zum einen in Stromlaufplänen verzeichnet werden müssen, zum anderen auch bezeichnet werden müssen und auch in Bezug auf den Anschluss bzw. den Einbau umfassend mit Montageanweisungen versehen sein müssen. Auch ist einzelnen Komponenten ein Prüfprotokoll oder dergleichen beizufügen.

Die Aufzeichnung einzelner Komponenten als auch die Anordnung von Bezeichnern ist aufwändig. Zudem ist in größeren Schaltanlagen bei vergleichsweise geringem Bauraum kaum noch Platz, um eine individuelle Bezeichnung anzubringen.

Im Installations- als auch Wartungsfall sind wegen des fehlenden Bauraums in aller Regel keine typspezifischen Montageanweisungen in Reichweite, so dass diese jeweils explizit mitgeführt werden müssen.

Die zunehmende Bauraumbeschränkung führt weiterhin dazu, dass auf Anzeigen weitestgehend verzichtet wird, da diese kostbaren Bauraum verwenden.

Gleichzeitig wäre es wünschenswert weitere Daten der Komponenten zu erhalten, um so einen Austausch bereits im Vorfeld planen oder einen bald bevorstehenden Ausfall auf Grund von tatsächlichen Alterungserscheinungen im Vorfeld zu erkennen und die betroffene Komponenten auszutauschen.

Der Erfindung liegt die Aufgabe zu Grunde, ein verbessertes elektrisches Interfacemodul zur Verfügung zu stellen, das einen Nachteil oder mehrere Nachteile aus dem Stand der Technik in erfinderischer Weise umgeht.

Die Lösung der Aufgabe erfolgt erfindungsgemäß durch die Merkmale des unabhängigen Anspruchs. Vorteilhafte Ausgestaltungen der Erfindung sind insbesondere in den Unteransprüchen angegeben.

Nachfolgend wird die Erfindung unter Bezugnahme auf die anliegende Zeichnung anhand bevorzugter Ausführungsformen näher erläutert.

### Es zeigt

- Fig. 1: eine schematische Darstellung eines elektrischen Interfacemoduls gemäß einer bevorzugten Ausführungsform der Erfindung,
- Fig. 2: eine explosionsartige schematische Darstellung einer beispielhaften Ausführungsform eines elektrischen Interfacemoduls gemäß der Erfindung,
- Fig. 3: eine explosionsartige schematische Darstellung einer weiteren beispielhaften Ausführungsform eines elektrischen Interfacemoduls gemäß der Erfindung, und
- Fig. 4: eine explosionsartige schematische Darstellung einer Vielzahl von elektrischen Interfacemodulen gemäß beispielhaften Ausführungsformen der Erfindung in Bezug auf einen Aspekt der Erfindung.

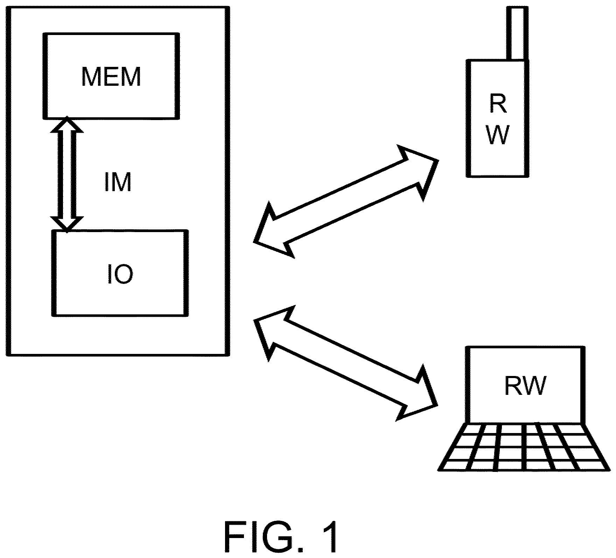

Die Figur 1 zeigt ein elektrisches Interfacemodul IM gemäß einer bevorzugten Ausführungsform der Erfindung.

Das elektrische Interfacemodul IM verfügt über eine Speichereinrichtung MEM zur Speicherung von Daten. Hierbei kann jede geeignete Form des Speichers verwendet werden. Beispielsweise kann als Speicher ein Flash-Speicher oder ein NAND-Speicher verwendet werden, da diese die Daten auch ohne Spannung halten können. Dies ist besonders hilfreich, wenn die entsprechende Komponente stromlos ist und keine Spannungsversorgung vorhanden ist.

Weiterhin weist das elektrische Interfacemodul IM auch eine integrierte NFC-Schnittstelle IO auf, welche Daten an ein externes Lesegerät, bzw. Schreib- und Lesegerät RW bereitstellt. Zudem werden die Erfordernisse an eine galvanische Trennung leichter erreichbar.

Die NFC-Schnittstelle IO kann aktiv oder passiv ausgestaltet sein. Bei einer passiven Ausgestaltung der NFC Schnittstelle IO bedarf diese keiner eigenen Spannungsversorgung, sondern die NFC-Schnittstelle IO wird aus der Funkenergie eines Lesegerätes oder Schreibgerätes bezogen. Dies ist besonders vorteilhaft, wenn die entsprechende Komponente stromlos ist und keine Spannungsversorgung vorhanden ist. Zudem werden die Erfordernisse an eine galvanische Trennung leichter erreichbar.

Die Daten, welche an das externe Lesegerät RW bereitgestellt werden, sind ausgewählt aus einer Gruppe, welche aufweist: Produktdaten, insbesondere eine Seriennummer und/oder Chargennummer und/oder ein Herstellungsdatum und/oder eine Herstelleridentifikation und/oder einen Herstellungsort, eine Bedienungsanleitung, eine Montageanleitung, ein Verweis auf eine Internetseite, Prüfdaten, insbesondere Daten der Fertigungsendprüfung, Zustandsdaten, insbesondere Fehlerstatus, Degradation, Konfigurationsdaten, insbesondere Parametrisierungsdaten.

Hiermit wird einem Verwender des erfindungsgemäßen elektrische Interfacemoduls IM eine Vielzahl von produktspezifischen Daten zur Verfügung gestellt, die es ihm erlauben einen gezielten Einsatz vorzusehen. Insbesondere wird die Inbetriebnahme einer Anlage deutlich vereinfacht, da nun nicht mehr Montagepläne vorgehalten werden müssen.

Weiterhin werden dem Verwender wichtige Zugangsdaten des elektrischen Interfacemoduls IM bereitgestellt, wie z.B. Fehlerstatus, Degradation, Konfigurationsdaten, insbesondere Parametrierungsdaten, die mit herkömmlichen Anzeigen nur schwer darstellbar sind, insbesondere unter der Randbedingung eines kleinen Bauraums.

In einer weiteren Ausgestaltung der Erfindung sind die Daten, welche an das externe Lesegerät RW bereitgestellt werden, ausgewählt aus einer Gruppe, welche aufweist: Daten einer Inbetriebnahme, Kennzeichnung eines Installationsortes, Daten einer Intervallprüfung, Statusanzeige, Auslesen über ein externes Lesegerät RW, Typ des verwendeten externen Lesegerätes RW, Klimadaten am Einbauort, insbesondere Temperatur und/oder Luftfeuchte, Netzspannungsfehler, Funktionsumfang, Parameterdaten, Ortskennung.

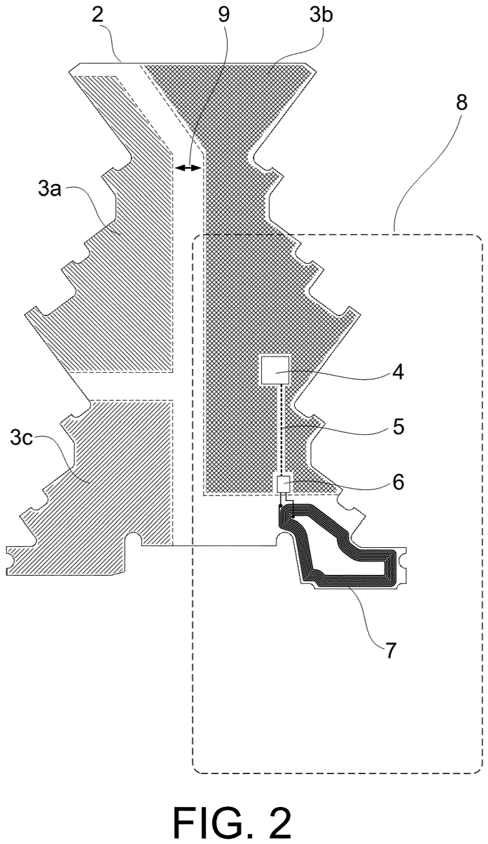

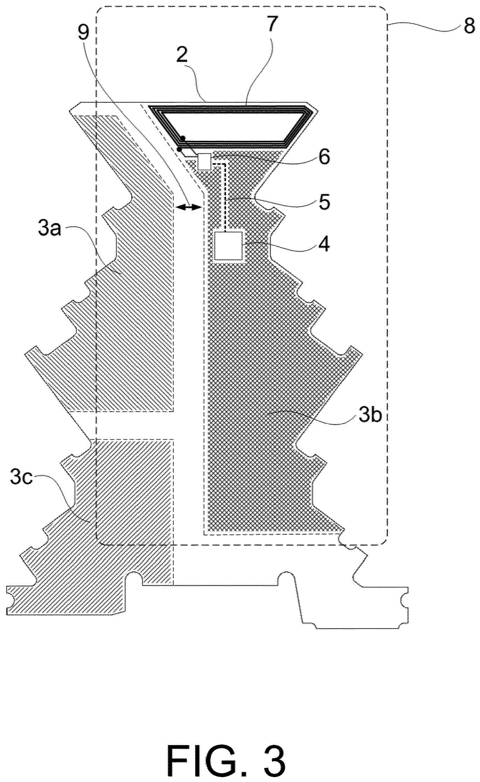

Diese Daten vereinfachen eine Überprüfung einer bestehenden Anlage. Weiterhin besteht die Möglichkeit zu unterscheiden, ob mittels eines besonderen Lesegerätes RW, wie z.B. mittels des in Figur 1 unten stilisierten Laptops, oder mit einer Smartphone-Anwendung, wie z.B. mittels des in Figur 1 oben bzw. in Figur 2 und 3 stilisierten Mobiltelefons 8, Daten ein oder ausgelesen werden. Die Erfindung ist jedoch nicht auf diese Ausführungsformen beschränkt sondern andere Ausführungsformen können z.B. einen Tablet-PC als Lesegerät 8 betreffen. Dabei kann die mögliche Orientierung des Lesegerätes RW, wie in Figur 2 und 3 in Bezug auf die jeweilige (planare) Antenne 7 gezeigt, unterschiedlich sein, wobei dies von der Ausgestaltung des jeweiligen Lesegerätes RW respektive des Mobiltelefons 8 und der jeweiligen elektrischen Interfacemodule IM abhängig sein kann.

In einer weiteren Ausgestaltung der Erfindung ist die integrierten NFC-Schnittstelle IO so ausgestaltet, dass Daten von einem externen Schreibgerät RW bereitstellt und in der Speichereinrichtung MEM abgespeichert werden.

In dieser weiteren Ausgestaltung der Erfindung ist es bevorzugt, wenn die bereitgestellten Daten, welche von dem externe Lesegerät RW bereitgestellt werden, ausgewählt sind aus einer Gruppe, welche aufweist: Produktdaten, insbesondere eine Seriennummer und/oder Chargennummer und/oder ein Herstellungsdatum und/oder eine Herstelleridentifikation und/oder einen Herstellungsort, eine Bedienungsanleitung, eine Montageanleitung, ein Verweis auf eine Internetseite, Prüfdaten, insbesondere Daten der Fertigungsendprüfung, Daten zur Nachbestellung beim Hersteller. Durch die Bereitstellung eines Einschreibens von Daten wird es ermöglicht alle relevanten Produktionsdaten, insbesondere Prüfdaten und Seriennummern nach Produktion des elektrischen Interfacemoduls IM abzulegen, ohne dass es eines physikalisch kontaktbehafteten Zugangs zum Speicher MEM bedarf.

In dieser weiteren Ausgestaltung der Erfindung ist es ebenfalls bevorzugt, wenn die Daten, welche von dem externen Lesegerät RW bereitgestellt werden, ausgewählt sind aus einer Gruppe, welche aufweist: Daten einer Inbetriebnahme, Kennzeichnung eines Installationsortes, Daten einer Intervallprüfung, Auslesen über ein externes Lesegerät RW, Typ des verwendeten externen Lesegerätes RW. Diese Daten vereinfachen eine Überprüfung einer bestehenden Anlage.

In dieser weiteren Ausgestaltung der Erfindung ist es ebenfalls bevorzugt, wenn die Daten, welche von dem externen Lesegerät RW bereitgestellt werden, Konfigurationsdaten für die Betriebsweise des elektrischen Interfacemoduls IM enthalten. So können beispielsweise die Konfigurationsdaten verschiedene Temperaturkennlinien, Spannungs- oder Strombereiche oder andere kundenspezifische Einstellungen beinhalten. Hierdurch kann das elektrische Interfacemodul IM mit Hilfe der NFC-Schnittstelle IO personalisiert oder konfiguriert bzw. parametriert werden.

Dies ist insbesondere für den passiven Betriebsmodus der NFC-Schnittstelle IO vorteilhaft, da individuelle Konfigurationsdaten im Vorfeld, z.B. auch im verpackten Zustand des elektrischen Interfacemoduls IM, kontaktlos in den Speicher MEM geschrieben werden können und bei Inbetriebnahme für das Interfacemodul IM zur Verfügung stehen können.

Ohne weiteres kann vorgesehen sein, dass zumindest ein Teil der Daten, welche produktspezifisch sind, schreibgeschützt oder passwortgeschützt hinterlegt werden. Auch zumindest ein Teil der anlagenspezifischen Daten können schreibgeschützt oder passwortgeschützt hinterlegt werden. Dabei können unterschiedliche Schutzmechanismen und/oder Passwörter vorgesehen sein.

Zudem kann vorgesehen sein, dass der Datenbereich von Betriebsdaten bei Verwendung einer NFC-Schnittstelle nur ausgelesen werden können.

Obwohl das Schreibgerät als auch das Lesegerät als getrennte Geräte beschrieben sind, kann die Funktionalität auch in einem Gerät vereinigt verfügbar sein.

Mittels der erfindungsgemäßen elektrischen Interfacemodule IM können die Komponenten durch Datenübernahme zum einen einfach in Stromlaufplänen verzeichnet werden, zum anderen können aber auch die elektrischen Interfacemodule IM gemäß der Stromlaufpläne bezeichnet werden. Zudem lassen sich mittels des erfindungsgemäßen elektrischen Interfacemoduls IM auch Montageanleitungen in Bezug auf den Anschluss bzw. den Einbau bereitstellen, so dass diese stets am Ort des Einbaus vorhanden sind. Hierdurch wird eine getrennte Lagerung bzw. Bevorratung der Montageanweisungen unnötig. Zudem können den erfindungsgemäßen elektrischen Interfacemodulen IM jeweils ein Prüfprotokoll oder dergleichen beigefügt werden.

Insbesondere in größeren Schaltanlagen, in denen wenig Platz zur Verfügung steht, wird durch die Erfindung die Bezeichnung deutlich vereinfacht bzw. sinnvoll ermöglicht.

Zudem lassen sich mittels der erfindungsgemäßen elektrischen Interfacemodule IM auch weitergehende Anzeigen realisieren, die ansonsten auf Grund von Bauraumvorgaben nicht möglich wären. Insbesondere wird es durch die Erfindung ermöglicht weitere Daten des elektrischen Interfacemoduls IM zu erhalten, um so einen Austausch bereits im Vorfeld planen oder einen bald bevorstehenden Ausfall auf Grund von tatsächlichen Alterungserscheinungen im Vorfeld zu erkennen und die betroffene Komponenten auszutauschen.

Die Verwendung von NFC-Schnittstellen erweist sich zudem als vorteilhaft, da eine größere Datenmenge bereitgestellt werden kann. Insbesondere können die Daten als xml-Daten hinterlegt sein.

Die vorgestellte Bauweise erlaubt es insbesondere flache elektrische Interfacemodule IM herzustellen, wodurch der Platzbedarf minimiert wird und zugleich neue Funktionalität bereitgestellt werden kann. Insbesondere erlaubt die vorgestellte Bauweise elektrische Interfacemodule IM bereitzustellen, die eine Breite von weniger als 36 mm, insbesondere weniger als 23 mm, insbesondere weniger als 18 mm, insbesondere weniger als 13 mm aufweist, und besonders bevorzugt von weniger als 7 mm aufweisen.

Beispielsweise in der Ausführungsform mit 7 mm erlaubt die Bauweise einen zumindest einseitig SMD-bestückten Träger 2, beispielsweise eine Platine, der die NFC-Schnittstelle IO als auch die eigentlichen Interfaceelemente aufweist. Ohne weiteres kann dieser Träger 2 dann in einem schmalen Gehäuse angeordnet werden. Weiterhin sind auf dem Träger unterschiedliche Bereiche 3a, 3b, 3c gekennzeichnet, die z.B. für unterschiedliche Aufgaben des elektrischen Interfacemoduls bzw. der hierfür benötigten Komponenten zur Verfügung stehen. Alternativ oder zusätzlich können die unterschiedlichen Bereiche 3a, 3b und 3c auch unterschiedliche Potentialgruppen kennzeichnen, die beispielsweise galvanisch voneinander getrennt sind und mit Hilfe von Koppelelementen gekoppelt werden können. Eine solche beispielhafte Anordnung ist in den Figuren 2 und 3 gezeigt.

Alternative oder zusätzlich kann auch ein drahtgebundenes Bussystem vorgesehen sein. Insbesondere kann auch ein beispielhaftes Bussystem vorgesehen sein, dass in der Montageschiene 11 befindlich ist und das von den einzelnen elektrischen Interfacemodulen IM beim Aufsetzen auf die Montageschiene 11 kontaktiert wird.

In einer weiteren Ausführungsform ist vorgesehen, dass der Träger 2 eine planare Antenne 7 für die integrierten NFC-Schnittstelle IO aufweist. Hierdurch wird zum einen ein verbesserter Austausch zwischen den einzelnen elektrischen Interfacemodulen IM ermöglicht und zum anderen flache elektrische Interfacemodule IM bereitgestellt.

Die integrierte NFC-Schnittstelle kann z.B., wie in den Figuren 2 und 3 schematisch gezeigt, aufgebaut sein. Dabei kann die NFC-Schnittstelle IO neben der eigentlichen Sende- und Empfangseinheit, welche z.B. in einem Chip 6 präsent ist, auch eine (planare) Antenne 7 aufweisen. Ohne weiteres kann der Chip 6 in einigen Ausführungsformen auch die Antenne 7 bereits integriert aufweisen oder eine Antenne kann als Komponente, beispielsweise als Spule, hinzugefügt werden. Offensichtlich kann solch eine Spule, die als Antenne 7 wirkt, auch als SMD-bestückbares Bauteil oder als Antenne im Kunststoffgehäuse oder mittels einer Folie an der Gehäusewand geklebt ausgeführt sein. Eine (planare) Antenne kann zudem auch als ein eigenständiges Bauteil ausgeführt sein, anderenfalls kann die planare Antenne 7 aber auch aus Leiterbahnen auf dem Träger 2 hergestellt sein. Zudem besteht mittels einer geeigneten Verbindung auch mit anderen Teilen auf dem elektrischen Interfacemodul IM Verbindung. Beispielhaft ist in den Figuren 2 und 3 eine Verbindung über eine weitere Schnittstelle 5 zu einem Controller 4 gezeigt. Beispielhafte Schnittstellen können neben einem 1-Wire Bus auch andere serielle oder parallele Schnittstellen oder andere Schnittstellen, wie z.B. einen I²C-Bus, aufweisen. Der Controller kann ein Mikrocontroller oder aber jede andere Logikschaltung sein.

In den Figuren 2 und 3 und 4 sind verschiedene Ausführungsformen in verschiedenen Ansichten gezeigt. Dabei ist das elektrische Interfacemodul IM zur Montage auf einer Montageschiene 11 geeignet. Eine beispielhafte Montageschiene 11 kann z.B. eine Hutschiene sein.

In der Ausführungsform, welche in Figur 2 gezeigt ist, ist die (planare) Antenne 7 im Nachbarbereich des Montagebereichs für die Montageschiene 11 angeordnet. Hierdurch verbleibt für die eigentlichen Interfacebausteine und die Anschlüsse bzw. Anzeigen im gegenüberliegenden Bereich mehr Bauraum.

In der Ausführungsform, welche in der Figur 3 gezeigt ist, ist die (planare) Antenne 7 in einem Bereich angeordnet, der dem Montagebereiche für die Montageschiene 11 gegenüberliegt. Hierdurch wird die Kommunikation mit einem externen Lesegerät RW erleichtert, so dass dieses bereits aus größerer Entfernung mit dem elektrischen Interfacemodul IM kommunizieren, d.h. Daten austauschen, kann.

Ohne weiteres ist für den Fachmann ersichtlich, dass auch andere Positionen zwischen diesen beiden Positionen für die (planare) Antenne 7 bzw. den Chip 6 vorgesehen sein können, um so von den jeweiligen Vorteilen zumindest teilweise zu profitieren.

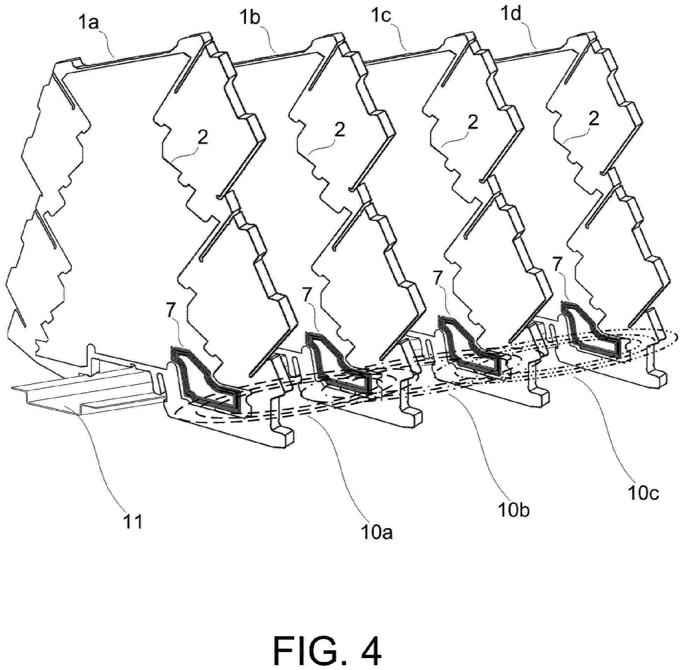

Dabei ist es von besonderem Vorteil, wenn benachbarte elektrische Interfacemodule IM so angeordnet sind, dass diese mit weiteren in der Nachbarschaft befindlichen elektrischen Interfacemodulen IM über die jeweils integrierte NFC-Schnittstelle IO Daten und/oder Energie austauschen können. Eine beispielhafte Anordnung hierzu ist in Figur 4 gezeigt, wobei hier der wünschenswerte - aber nicht notwendige Fall - der gleichartigen Anordnung der NFC-Schnittstellen zumindest in Bezug auf die jeweiligen (planaren) Antennen 7 gezeigt ist. Beispielhaft sind in Figur 4 aneinandergereihte elektrische Interfacemodule IM gezeigt, die jeweils ein eigenes Gehäuse 1a, 1b, 1c, ... aufweisen. Innerhalb des Gehäuses ist zumindest ein Träger 2 angeordnet, auf dem sich wiederum eine (planare) Antenne 7 befindet. Zur vereinfachten Darstellung sind nun jeweils beispielhafte magnetische Feldlinien dargestellt, wie sie sich beim Daten- und/oder Energieaustausch zwischen den einzelnen elektrischen Interfacemodulen IM ausbilden könnten. Z.B könnte sich von dem ersten Interfacemodul IM, welches in einem Gehäuse 1a befindlich ist, die Feldlinien 10a - dargestellte mittels gestichelter Linien - ausbilden. Diese Feldlinien 10a können z.B. in den Bereich der (planaren) Antenne 7 des zweiten, zum ersten direkt benachbarten, Interfacemoduls eingreifen, so dass mittels des Feldes Energie und / oder Daten zwischen den benachbarten Interfacemodulen ausgetauscht werden können. In gleicher Weise ist dies auch für das zweite Interfacemodul möglich, wobei hier zur Unterscheidung die magnetischen Feldlinien 10b mittels strich-punktierter Linien dargestellt sind. Ohne weiteres können die Feldlinien natürlich auch dergestalt sein, dass sie über ein benachbartes Interfacemodul hinaus auch Energie- und Daten übertragen können. So können z.B. Lücken und/oder fehlerhafte Module überbrückt werden, und / oder, wie später noch beschrieben werden wird, sogar als fehlerhaft erkannt und / oder neu konfiguriert werden.

In einer beispielhaften Ausführung sind die benachbarten Interfacemodule IM so ausgestaltet, dass benachbarte elektrische Interfacemodule IM einen logischen Datenbus über die integrierten NFC-Schnittstellen IO bilden, der mittels mindestens eines Kopfmoduls oder eines Mastermoduls mit einer höheren Steuer- und/oder Überwachungseinrichtung angesprochen und/oder gesteuert werden kann. Beispielsweise kann eines der Interfacemodule zu der Funktion eines Mastermoduls bestimmt sein, oder aber, ein spezielles Kopfmodul, welches als Master fungiert, wird an einer Seite von benachbarten elektrischen Interfacemodulen IM oder zwischen benachbarte elektrische Interfacemodule IM eingebracht.

In einer Ausführungsform ist z.B. vorgesehen, dass benachbarte elektrische Interfacemodule IM ein Ad-Hoc-Netzwerk bilden

Soweit vorstehend auf eine NFC-Schnittstelle Bezug genommen wurde, ist die Erfindung nicht auf NFC beschränkt, sondern lediglich ein Beispiel für eine Nahfeldübertragungstechnik. Eine andere beispielhafte Nahfeldübertragungstechnik ist beispielsweise RFID, die als eine Alternative zu NFC verwendet werden kann.

**Bezugszeichenliste**

| | |
|---|---|
| Elektrisches Interfacemodul | IM |
| Speicher | MEM |
| NFC-Schnittstelle / RFID-Schnittstelle | IO |
| Schreibgerät, Lesegerät | RW |
| Gehäuse | 1; 1a, 1b, 1c |
| Träger | 2 |
| Komponentenbereiche | 3a, 3b, 3c |
| Controller | 4 |
| Schnittstelle | 5 |
| Schnittstellen-Chip | 6 |
| Antenne (planar) | 7 |
| Mobiltelefon, Smartphone, Tablet-PC | 8 |
| (magnetische) Feldlinien | 10a, 10b, 10c |
| Montageschiene | 11 |

## Patentansprüche

1. Elektrisches Interfacemodul (IM), welches eine Speichereinrichtung (MEM) zur Speicherung von Daten und eine integrierte NFC-Schnittstelle (IO) aufweist, welche Daten an ein externes Lesegerät (RW) bereitstellt, wobei das elektrische Interfacemodul (IM) einen Träger (2) beinhaltet, auf dem die Speichereinrichtung (MEM) und die integrierte NFC-Schnittstelle (IO) angeordnet sind, **dadurch gekennzeichnet, dass** das elektrische Interfacemodul (IM) einen Montagebereich aufweist, der zur Montage auf einer Montageschiene (11) geeignet ist, und der Träger (2) eine planare Antenne (7) für die integrierte NFC-Schnittstelle (IO) aufweist,
• wobei die planare Antenne (7) benachbart zum Montagebereich für die Montageschiene (11) angeordnet ist, sodass die Fläche der planaren Antenne (7) im Wesentlichen senkrecht zu einer Längserstreckung der Montageschiene (11) ist, oder
• wobei die planare Antenne (7) in einem Bereich angeordnet ist, der dem Montagebereich für die Montageschiene (11) gegenüberliegt.

2. Elektrisches Interfacemodul (IM) nach Anspruch 1, wobei die Daten, welche an das externe Lesegerät (RW) bereitgestellt werden, ausgewählt sind aus einer Gruppe, welche aufweist:
• Produktdaten, insbesondere eine Seriennummer und/oder Chargennummer und/oder ein Herstellungsdatum und/oder eine Herstelleridentifikation und/oder einen Herstellungsort,
• eine Bedienungsanleitung,
• eine Montageanleitung,
• ein Verweis auf eine Internetseite,
• Prüfdaten, insbesondere Daten der Fertigungsendprüfung,
• Daten zur Nachbestellung beim Hersteller,
• Zustandsdaten, Fehlerstatus, Degradation,
• Konfigurationsdaten, Parametrisierungsdaten.

3. Elektrische Interfacemodul (IM) nach Anspruch 2, wobei zumindest ein Teil der Daten schreibgeschützt oder passwortgeschützt sind.

4. Elektrische Interfacemodul (IM) nach Anspruch 1, 2 oder 3, wobei die Daten, welche an das externe Lesegerät (RW) bereitgestellt werden, ausgewählt sind aus einer Gruppe, welche aufweist: Daten einer Inbetriebnahme, Kennzeichnung eines Installationsortes, Daten einer Intervallprüfung, Statusanzeige, Auslesen über eine externes Lesegerät (RW), Typ des verwendeten externen Lesegerätes (RW), Klimadaten am Einbauort, Temperatur und/oder Luftfeuchte, Netzspannungsfehler, Funktionsumfang, Parameterdaten, Ortskennung.

5. Elektrische Interfacemodul (IM) nach einem der Ansprüche 1 bis 4, wobei die integrierte NFC-Schnittstelle (IO) so ausgestaltet ist, dass Daten von einem externen Schreibgerät (RW) bereitstellt und in der Speichereinrichtung (MEM) abgespeichert werden.

6. Elektrische Interfacemodul (IM) nach Anspruch 5, wobei zumindest ein Teil der Daten schreibgeschützt oder passwortgeschützt sind.

7. Elektrische Interfacemodul (IM) nach Anspruch 5 oder 6, wobei die bereitgestellten Daten, welche von dem externen Lesegerät (RW) bereitgestellt werden, ausgewählt sind aus einer Gruppe, welche aufweist:
• Produktdaten, eine Seriennummer und/oder Chargennummer und/oder ein Herstellungsdatum und/oder eine Herstelleridentifikation und/oder einen Herstellungsort,
• eine Bedienungsanleitung,
• eine Montageanleitung,
• ein Verweis auf eine Internetseite,
• Konfigurationsdaten, Parametrisierungsdaten,
• Prüfdaten, Daten der Fertigungsendprüfung.

8. Elektrische Interfacemodul (IM) nach einem der Ansprüche 5 bis 7, wobei die Daten, welche von dem externen Lesegerät (RW) bereitgestellt werden, ausgewählt sind aus einer Gruppe, welche aufweist: Daten einer Inbetriebnahme, Kennzeichnung eines Installationsortes, Daten einer Intervallprüfung, Auslesen über ein externes Lesegerät (RW), Typ des verwendeten externen Lesegerätes (RW).

9. Elektrische Interfacemodul (IM) nach Anspruch 8, wobei zumindest ein Teil der Daten schreibgeschützt oder passwortgeschützt sind.

10. Elektrische Interfacemodul (IM) nach einem der vorhergehenden Ansprüche, wobei die NFC-Schnittstelle (IO) eine passive NFC-Schnittstelle (IO) ist.

11. Elektrisches Interfacemodul (IM) nach einem der vorhergehenden Ansprüche, wobei das elektrische Interfacemodul (IM) eine Breite von weniger als 7 mm aufweist.

12. Elektrisches Interfacemodul (IM) nach einem der vorhergehenden Ansprüche, wobei das elektrische Interfacemodul (IM) eine Breite von weniger als 36 mm, weniger als 23 mm, bevorzugt weniger als 18 mm, besonders bevorzugt weniger als 13 mm aufweist.

13. Elektrisches Interfacemodul (IM) nach einem der vorhergehenden Ansprüche, wobei der Träger (2) eine planare Antenne (7) für die integrierte NFC-Schnittstelle (IO) aufweist.

14. Elektrisches Interfacemodul (IM) nach einem der vorhergehenden Ansprüche, wobei das elektrische Interfacemodul (IM) mit weiteren in der Nachbarschaft befindlichen elektrischen Interfacemodulen (IM) nach einem der vorhergehenden Ansprüche über die integrierte NFC-Schnittstelle Daten austauschen kann und/oder Energie beziehen kann.

## Claims

1. An electrical interface module (IM), comprising a memory device (MEM) for storing data and an integrated NFC interface (IO) that provides data to an external reading device (RW), the electrical interface module (IM) containing a carrier (2) on which the memory device (MEM) and the integrated NFC interface (IO) are arranged, **characterized in that** the electrical interface module (IM) is arranged for mounting on a mounting rail (11), and the carrier (2) comprises a planar antenna (7) for the integrated NFC interface (IO),
• wherein the planar antenna (7) is arranged in the vicinity of the mounting region for the mounting rail (11) such that the plane of the planar antenna (7) is substantially perpendicular to a longitudinal extension of the mounting rail (11), or
• wherein the planar antenna (7) is arranged in a region opposite the mounting region for the mounting rail (11).

2. The electrical interface module (IM) as set forth in claim 1, wherein the data that are made available to the external reading device (RW) are selected from a group comprising:
• product data, particularly a serial number and/or batch number and/or a manufacturing date and/or a manufacturer identification and/or a place of manufacture,
• an operating manual,
• assembly instructions,
• a reference to an Internet page,
• test data, particularly data from the final manufacturing inspection,
• information for reordering from the manufacturer,
• status data, particularly error status, degradation,
• configuration data, particularly parameterization data.

3. The electrical interface module (IM) as set forth in claim 2, wherein at least a portion of the data is write-protected or password-protected.

4. The electrical interface module (IM) as set forth in claim 1, 2 or 3, wherein the data that are made available to the external reading device (RW) are selected from a group comprising: startup data, identification of an installation site, periodic inspection data, status indicator, readout via an external reading device (RW), type of external reading device (RW) used, climate data at the installation site, particularly temperature and/or atmospheric humidity, mains voltage failure, functional range, parameter data, site identification.

5. The electrical interface module (IM) as set forth in any one of claims 1 to 4, wherein the integrated NFC interface (IO) is embodied such that data are made available by an external writing device (RW) and stored in the memory device (MEM).

6. The electrical interface module (IM) as set forth in claim 5, wherein at least a portion of the data is write-protected or password-protected.

7. The electrical interface module (IM) as set forth in claim 5 or 6, wherein the data that are made available by the external reading device (RW) are selected from a group comprising:
• product data, particularly a serial number and/or batch number and/or a manufacturing date and/or a manufacturer identification and/or a place of manufacture,
• an operating manual,
• assembly instructions,
• a reference to an Internet page,
• configuration data, particularly parameterization data,
• test data, particularly data from the final manufacturing inspection.

8. The electrical interface module (IM) as set forth in any one of claims 5 to 7, wherein the data that are made available by the external reading device (RW) are selected from a group comprising: startup data, identification of an installation site, periodic inspection data, readout via an external reading device (RW), type of external reading device (RW) used.

9. The electrical interface module (IM) as set forth in claim 8, with at least a portion of the data being write-protected or password-protected.

10. The electrical interface module (IM) as set forth in any one of the preceding claims, wherein the NFC interface (IO) is a passive NFC interface (IO).

11. The electrical interface module (IM) as set forth in any one of the preceding claims, wherein the electrical interface module (IM) has a width of less than 7 mm.

12. The electrical interface module (IM) as set forth in any one of the preceding claims, wherein the electrical interface module (IM) has a width of less than 36 mm, particularly less than 23 mm, particularly less than 18 mm, particularly less than 13 mm.

13. The electrical interface module (IM) as set forth in any one of the preceding claims, wherein the carrier (2) has a planar antenna (7) for the integrated NFC interface (IO) .

14. The electrical interface module (IM) as set forth in any one of the preceding claims, wherein the electrical interface module (IM) can exchange data and/or power with other electrical interface modules (IM) located in the vicinity as set forth in any one of the preceding claims via the integrated NFC interface.

## Revendications

1. Module d'interface électrique (IM) qui présente un dispositif de mémoire (MEM) pour la sauvegarde de données et une interface NFC intégrée (IO) qui met des données à disposition d'un lecteur externe (RW), le module d'interface électrique (IM) contenant un support (2) sur lequel le dispositif de mémoire (MEM) et l'interface NFC intégrée (IO) sont disposés, **caractérisé en ce que** le module d'interface électrique (IM) présente une zone de montage qui est apte à être montée sur un rail de montage (11) et que le support (2) présente une antenne planaire (7) pour l'interface NFC intégrée (IO),
• l'antenne planaire (7) étant disposée à proximité de la zone de montage pour le rail de montage (11), de sorte que la surface de l'antenne planaire (7) est sensiblement perpendiculaire à une extension longitudinale du rail de montage (11), ou
• l'antenne planaire (7) étant disposée dans une zone qui est opposée à la zone de montage pour le rail de montage (11).

2. Module d'interface électrique (IM) selon la revendication 1, dans lequel les données qui sont mises à la disposition du lecteur externe (RW) sont sélectionnées dans un groupe qui présente :
• des données de produit, en particulier un numéro de série et/ou un numéro de lot et/ou une date de fabrication et/ou un identifiant de fabricant et/ou un lieu de fabrication,
• un mode d'emploi,
• une notice de montage,
• un renvoi à un site Internet,
• des données de contrôle, en particulier des données du contrôle final de fabrication,
• des données pour repasser commande chez le fabricant,
• des données d'état, un état d'erreurs, de dégradation,
• des données de configuration, des données de paramétrisation.

3. Module d'interface électrique (IM) selon la revendication 2, dans lequel au moins une partie des données est en lecture seule ou est protégée par mot de passe.

4. Module d'interface électrique (IM) selon la revendication 1, 2 ou 3, dans lequel les données qui sont mises à disposition du lecteur externe (RW) sont sélectionnées dans un groupe qui présente : des données d'une mise en service, un identifiant d'un lieu d'installation, des données d'un contrôle périodique, un indicateur d'état, la lecture par un lecteur externe (RW), le type de lecteur externe utilisé (RW), des données climatologiques au lieu de montage, la température et/ou l'hygrométrie, les défaillances de tension de secteur, l'étendue fonctionnelle, des données de paramètres, un identifiant de lieu.

5. Module d'interface électrique (IM) selon une des revendications 1 à 4, dans lequel l'interface NFC intégrée (IO) est conçue de manière à ce que les données soient mises à disposition par un instrument d'écriture externe (RW) et sauvegardées dans le dispositif de mémoire (REM).

6. Module d'interface électrique (IM) selon la revendication 5, dans lequel au moins une partie des données sont en lecture seule ou protégées par mot de passe.

7. Module d'interface électrique (IM) selon la revendication 5 ou 6, dans lequel les données mises à dispositions qui sont mises à disposition par le lecteur externe (RW) sont sélectionnées dans un groupe qui présente :
• des données de produit, un numéro de série et/ou un numéro de lot et/ou une date de fabrication et/ou un identifiant de fabricant et/ou un lieu de fabrication,
• un mode d'emploi,
• une notice de montage,
• un renvoi à un site Internet,
• des données de configuration, des données de paramétrisation,
• des données de contrôle, des données du contrôle final de fabrication.

8. Module d'interface électrique (IM) selon une des revendications 5 à 7, dans lequel les données mises à disposition par le lecteur externe (RW) sont sélectionnées dans un groupe qui présente : des données d'une mise en service, un identifiant d'un lieu d'installation, des données d'un contrôle périodique, un indicateur d'état, la lecture par un lecteur externe (RW), le type de lecteur externe utilisé (RW).

9. Module d'interface électrique (IM) selon la revendication 8, dans lequel au moins une partie des données sont en lecture seule ou protégées par mot de passe.

10. Module d'interface électrique (IM) selon une des revendications précédentes, dans lequel l'interface NFC (IO) est une interface NFC passive (IO).

11. Module d'interface électrique (IM) selon une des revendications précédentes, dans lequel le module d'interface électrique (IM) présente une largeur de moins de 7 mm.

12. Module d'interface électrique (IM) selon une des revendications précédentes, dans lequel le module d'interface électrique (IM) présente une largeur de moins de 36 mm, moins de 23 mm, de préférence moins de 18 mm, très préférentiellement de moins de 13 mm.

13. Module d'interface électrique (IM) selon une des revendications précédentes, dans lequel le support (2) présente une antenne planaire (7) pour l'interface NFC intégrée (IO).

14. Module d'interface électrique (IM) selon une des revendications précédentes, dans lequel le module d'interface électrique (IM) peut échanger des données avec d'autres modules d'interface électrique (IM) selon une des revendications précédentes se trouvant dans le voisinage et/ou se procurer de l'énergie par l'intermédiaire de l'interface NFC intégrée.
